# EUROPÄISCHE PATENTSCHRIFT

(11) **EP 0 729 695 B1**
(45) Veröffentlichungstag und Bekanntmachung des Hinweises auf die Patenterteilung: **08.10.1997**
(21) Anmeldenummer: 94931510.5
(22) Anmeldetag: 04.11.1994
(51) Int. Cl.: H05K 7/14, G06F 1/18

(54) **ANSCHLUSSFELD FÜR STEUERGERÄT**
JUNCTION PANEL FOR CONTROL UNIT
PANNEAU DE RACCORDEMENT POUR APPAREIL DE COMMANDE

(30) Priorität: 15.11.1993 DE 4338987
(43) Veröffentlichungstag der Anmeldung: 04.09.1996
(73) Patentinhaber: Siemens Nixdorf Informationssysteme AG, 33106 Paderborn (DE)
(72) Erfinder: BAITZ, Günter, D-13503 Berlin (DE); KAMIN, Hartmut, D-10585 Berlin (DE)
(74) Vertreter: Fuchs, Franz-Josef, Dr.-Ing.
(86) Internationale Anmeldenummer: DE9401304
(87) Internationale Veröffentlichungsnummer: WO9514367

(56) Entgegenhaltungen:
- DE-U- 9 101 940
- DE-U- 9 316 277
- IBM TECHNICAL DISCLOSURE BULLETIN., Bd.34, Nr.2, Juli 1991, NEW YORK US Seiten 198 - 199, XP211080 'Rear panel design for personal computer systems'

## Beschreibung

Die Erfindung betrifft ein elektronisches Steuergerät nach dem Oberbegriff des Anspruchs 1.

Ein bekanntes Steuergerät der genannten Art ist als sogenannte Elektronikbox des Beetle-Kassensystems der Firma Siemens Nixdorf Informationssysteme AG, Paderborn, bekannt. (Siemens Nixdorf Informationssysteme AG: Service Manual "Kassensysteme BEETLE x/50 und x/60" vom September 1993, Seiten 4-1 und 4-2). Das Steuergerät ist weitgehend aus Komponenten der PC-Welt aufgebaut.

Aus der DE-U-91 01 940.0 ist eine Haltevorrichtung bekannt, die dazu dient, eine Zusatzleiterplatte mit einer Blende nach dem PC-Standard - dort Computer-Interfacekarte genannt - in einem Notizbuchcomputer anzuordnen. In einer Seitenwand des Computergehäuses ist ein Durchbruch vorgesehen, durch den auf der Blende der Zusatzleiterplatte angeordnete Anschlußstecker zugänglich sind. Der Durchbruch ist parallel zu einer Reihe von Steckern angeordnet, die einer zentralen Verarbeitungseinheit zugeordnet sind.

Insbesondere bei Kassensystemen, bei denen häufig eine größere Zahl von Peripheriegeräten angeschlossen wird als bei Büro-Personal Computer-Anwendungen, ergibt sich immer wieder das Problem, daß an der Rückwand nicht genügend Raum für Anschlußstecker und von außen zugängliche Bedienelemente zur Verfügung steht. Dieses Problem wird noch dadurch verschärft, daß mit fortschreitender Entwicklung trotz der Integration von immer mehr Funktionen in die Elektronikbox deren Baugröße immer kleiner wird.

Die Erfindung stellt sich daher die Aufgabe, zusätzlichen Stecker- und Anschlußraum zur Verfügung zu stellen, ohne die bei PC's übliche funktionelle Zuordnung der Leiterplatten und der Bauform von deren Anschlußfeldern aufzugeben.

Diese Aufgabe wird durch die kennzeichnenden Merkmale des Anspruchs 1 gelöst.

Die Erfindung geht von der Beobachtung aus, daß bei PC-basierten elektronischen Steuergeräten alle für die Grundfunktionen erforderlichen elektronischen Bauelemente auf einer Basisplatte - dem sogenannten Mother board -angeordnet sind. Es sind dies im wesentlichen die CPU, der Arbeitsspeicher, der Tastaturcontroller und verschiedene Schnittstellencontroller. Baugruppen, die in unterschiedlichen Ausführungsformen verwendet werden, aber zur Grundausstattung zählen, wie z.B. der Bildschirmcontroller, werden als Tochter-Leiterplatten - sogenannte Piggy-pack boards - auf die Basisplatte aufgesteckt. Der Anschluß von der Tochterplatte zur Außenwelt wird über einen Stecker hergestellt, der an der Basisplatte angebracht ist. Optionale Ausstattungen werden durch das Hinzufügen von Zusatz-Leiterplatten, vorzugsweise sogenannte AT-Karten, verwirklicht. Dies können ihrerseits Tochter-Leiterplatten aufnehmen, wie z.B. Netzwerkcontroller, deren Anschluß zur Außenwelt über einen Stecker in der Blende der Zusatz-Leiterplatte führt. Die Zuordnung der Anschlußstecker erfolgt also in Reihen streng zu den einzelnen Leiterplattenebenen und ist damit in Zahl und Größe durch den für die jeweilige Ebene verfügbaren Raum begrenzt. Jeder dieser Ebenen sind Reihen von Öffnungen in der Gehäuserückwand zugeordnet.

Die vorgenannte Begrenzung kann überwunden werden, wenn zwischen der Reihe, die durch die Basis-Leiterplatte bestimmt wird, und der Reihe, die durch die Blende einer dieser benachbarten Zusatz-Leiterplatte definiert ist, eine weitere Reihe von Öffnungen für mögliche Stecker und/oder Kabel vorgesehen wird. Diese Reihe ist dann durch Stecker der Basis-, der Zusatz- und der Tochter-Leiterplatten der beiden erstgenannten Leiterplatten erreichbar. Anschlüsse dieser Tochter-Leiterplatten können dann direkt nach außen geführt werden und müssen nicht mehr über Stecker an der sie tragenden Leiterplatte geführt werden. Dadurch wird der sonst für diese Anschlußstecker benötigte Platz frei und kann anderweitig genutzt werden. Darüber hinaus entfällt ein Piggy-pack-Stecker, und der Platz für ihn und seine Anschlußleiterbahnen wird frei.

Die zusätzliche Reihe von Öffnungen ist auch für Stecker auf der Basis- und der Zusatzleiterplatte erreichbar. Dies wird insbesondere von Leiterplatten unterstützt, die nach der SMD-Technik bestückt sind. Diese Technik erlaubt nämlich den Aufbau von Bauelementen, also auch von Steckern auf beiden Seiten der Leiterplatte. Dabei können Stecker der einen Seite einer Reihe und Stecker der anderen Seite einer benachbarten Reihe zugeordnet werden. Gleiches gilt für die Tochterkarten.

Statt oder auch zusätzlich zu Tochter-Leiterplatten können auch Kartenschächte z.B. nach dem PCMCIA-Standard verwendet werden, deren Aufnahmeöffnung in der zusätzlichen Reihe von Öffnungen liegt. Diese Kartenschächte dienen der Aufnahme zusätzlicher Speicherkarten oder auch von kartenförmigen Schnittstellencontrollern oder Modems.

Soll die Aufnahmeöffnung von außen zugänglich sein, liegt sie unmittelbar bei einer Gehäuseöffnung. Soll sie betriebsmäßig nicht zugänglich oder nur nach Öffnen des Gerätegehäuses zugänglich sein, wird der Kartenschacht in das Gehäuseinnere zurückversetzt. Ein eventuell nötiges Anschlußkabel wird dann durch einen Kabeldurchlaß in der Rückwand geführt.

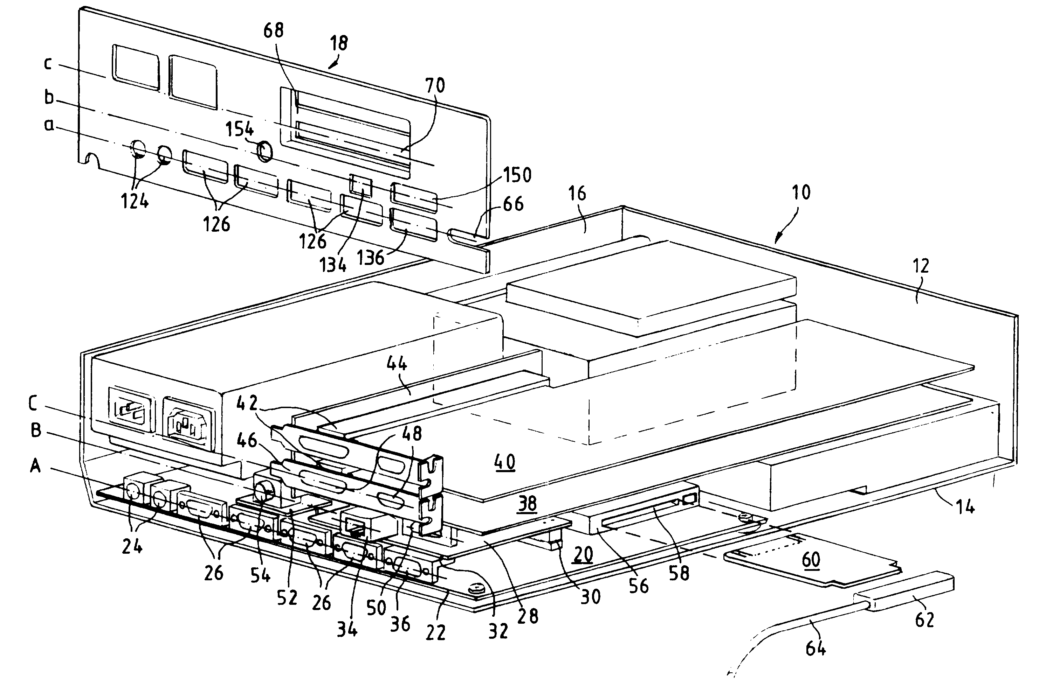

Weitere Merkmale und vorteilhafte Ausgestaltungen der Erfindung sind den Unteransprüchen und der Beschreibung und Zeichnung eines Ausführungsbeispiels zu entnehmen. Die einzige Figur zeigt die schematische Darstellung eines geöffneten elektronischen Steuergeräts in perspektivischer Draufsicht von der Rückseite her.

Darin ist ein elektronisches Steuergerät allgemein mit 10 bezeichnet. Sein Gehäuse ist nur in Teilen dargestellt, und zwar eine Frontplatte 12, eine Bodenplatte 14, eine Seitenwand 16 und eine Rückwand 18, die der besseren Darstellbarkeit des Geräteinneren wegen nach oben verschoben gezeigt ist. Die zweite Seitenwand und die Geräteabdeckung sind nicht dargestellt.

Im hinteren Gerätebereich ist parallel zur Bodenplatte 14 eine Basis-Leiterplatte 20 angeordnet, die sich im wesentlichen über die gesamte Gehäusebreite erstreckt. Ihre Hinterkante 22 ist mit verschiedenen Steckern 24 für den Anschluß von Tastaturen und 26 für Peripheriegeräte mit serieller Schnittstelle bestückt. Diese Stecker liegen in einer ersten Ebene A.

Auf die Basis-Leiterplatte 20 ist eine Tochter-Leiterplatte 28 aufgesteckt. Elektrisch und mechanisch sind die Leiterplatten 20 und 28 durch ein Stift-/Buchsenleistenpaar 30 miteinander verbunden. An ihrer der Rückwand zugewandten Seite 32 trägt die Tochter-Leiterplatte 28 eine Telefonanschlußbuchse 34. Diese liegt in einer zweiten Ebene B. Ein weiterer Anschlußstecker 36 für den Anschluß eines Bildschirmgerätes ist auf der Unterseite der Tochter-Leiterplatte 28 angeordnet und liegt somit in der ersten Ebene A.

Parallel zu der Basis-Leiterplatte 20 sind zwei Zusatz-Leiterplatten 38, 40 angeordnet. Sie sind über Randkantenstecker 42 mit einer AT-Bus-Rückwand 44 steckverbunden. Letztere ist in bekannter und deshalb nicht näher dargestellter Weise auf die Basis-Leiterplatte 20 aufgesteckt. Die Zusatz-Leiterplatten 38, 40 sind im wesentlichen gleich und nach dem PC-AT-Standard aufgebaut. Es wird deshalb nur auf die erste Zusatz-Leiterplatte 38 näher eingegangen.

Diese trägt eine Blende 46 nach dem PC-Standard. Auf die Blende sind Anschlußstecker 48 aufgesetzt, deren Kontakte mit der Zusatz-Leiterplatte 38 elektrisch verbunden sind.

Die Blende 46 liegt in einer dritten Ebene C. Auf der der Blende 46 abgewandten Seite der Zusatz-Leiterplatte 38 ist ein weiterer Stecker 50 angeordnet, der in der zweiten Ebene B liegt.

In der zweiten Ebene B liegt im Ausführungsbeispiel links neben der Tochter-Leiterplatte 28 eine weitere Leiterplatte 52 mit einem Spannungsversorgungsstecker 54 für Peripheriegeräte. Ebenfalls in der zweiten Ebene B, hinter der Tochter-Leiterplatte 28, ist ferner ein Kartenschacht 56 nach dem PCMCIA-Standard angeordnet, dessen Aufnahmeöffnung 58 zu einer Seite des Steuergerätes 10 weist. In diese ist eine Steckkarte 60, beispielsweise eine Modem-Karte einsteckbar. Auf diese wiederum ist der Stecker 62 eines Kabels 64 aufsteckbar. Wie aus der Zeichnung hervorgeht, ist der Kartenschacht 56 von der Geräteseite weg zum Geräteinneren hin versetzt, so daß sich ein Freiraum für das Kabel 64 ergibt, durch den dieses zur Rückwand 18 hin geführt werden kann. Dort gelangt es durch einen Kabeldurchlaß 66 nach außen.

Die Rückwand 18 ist mit Öffnungen 124, 126, 136 für die Stecker 24, 26, 36 sowie mit dem Kabeldurchlaß 66 versehen. Diese Öffnungen liegen in einer ersten Reihe a. Parallel zu dieser ist eine zweite Reihe b mit Öffnungen 134, 150, 154 für die Stecker 34, 50, 54 angeordnet. Darüber befindet sich ein PC-Anschlußfeld 68 mit einer Öffnung 70 in einer dritten Reihe c für die Blende 46 und einer weiteren Öffnung für die Blende der weiteren Zusatz-Leiterplatte 40.

## Patentansprüche

1. Elektronisches Steuergerät mit einem Gehäuse, in dem eine an einem Rand Anschlußstecker tragende Basis-Leiterplatte und parallel zu dieser wenigstens eine eine Blende nach dem PC-Standard tragende Zusatz-Leiterplatte angeordnet sind, wobei die Anschlußstecker der Basis-Leiterplatte durch in einer ersten Reihe angeordnete Öffnungen und die Blende durch eine zu dieser parallele Öffnung in einer Gehäusewand zugänglich sind,
**dadurch gekennzeichnet**, daß zwischen der ersten Reihe (a) von Öffnungen (66, 124, 126, 136) und der Öffnung (70) für die Blende (46) eine zu diesen parallele zweite Reihe (b) von Öffnungen (134, 150, 154) angeordnet ist, daß auf die Basis-Leiterplatte (20) und/oder auf die Zusatz-Leiterplatte (38) eine mit Anschlußsteckern (34, 36) versehene Tochter-Leiterplatte (28) aufsteckbar ist und daß deren Anschlußstecker (34; 36) durch Öffnungen (134; 136) der ersten (a) und/oder der zweiten Reihe (b) zugänglich sind.

2. Elektronisches Steuergerät nach Anspruch 1,
**dadurch gekennzeichnet**, daß die Öffnungen der ersten und/oder der zweiten Reihe (a, b) Stekkerdurchlasse (124, 126, 136; 134, 150, 154) und/oder Kabeldurchlasse (66) sind.

3. Elektronisches Steuergerät nach Anspruch 1 oder 2,
**dadurch gekennzeichnet,** daß durch die Steckerdurchlasse (134, 150, 154) der zweiten Reihe (b) Anschlußstecker (50) der Basis-Leiterplatte (20) und/oder der Zusatz-Leiterplatte (38) zugänglich sind.

4. Elektronisches Steuergerät nach einem der Ansprüche 1 bis 3, **dadurch gekennzeichnet**, daß zwischen der Basis-Leiterplatte (20) und der Zusatz-Leiterplatte (38) ein Kartenschacht für eine PCMCIA-Karte einbaubar ist, dessen Aufnahmeöffnung durch eine Öffnung der zweiten Reihe (b) zugänglich ist.

5. Elektronisches Steuergerät nach einem der Ansprüche 1 bis 3, **dadurch gekennzeichnet,** daß zwischen der Basis-Leiterplatte (20) und der Zusatz-Leiterplatte (38) ein Kartenschacht (56) für eine PCMCIA-Karte (60) einbaubar ist, dessen Aufnahmeöffnung (58) um 90° gegen die Gehäusewand (18) versetzt angeordnet ist und der so weit in das Gehäuseinnere zurückversetzt ist, daß sich von der Aufnahmeöffnung (58) bis zu einem Kabeldurchlaß (66) ein Kabelführungsraum ergibt.

## Claims

1. Electronic control unit having a housing in which a mother board, which has connection plugs at one edge, and, parallel thereto, at least one additional printed circuit board which has a frontplate according to the PC standard are arranged, the connection plugs of the mother board being accessible through apertures arranged in a first row and the frontplate being accessible through an aperture, parallel to the latter row, in a housing wall, characterized in that arranged between the first row (a) of apertures (66, 124, 126, 136) and the aperture (70) for the frontplate (46) is a second row (b) of apertures (134, 150, 154) parallel to said apertures, in that a daughter board (28) which is provided with connection plugs (34, 36) can be plugged onto the mother board (20) and/or onto the additional printed circuit board (38), and in that the connection plugs (34; 36) of the daughter board (28) are accessible through apertures (134; 136) of the first row (a) and/or of the second row (b).

2. Electronic control unit according to Claim 1, characterized in that the apertures of the first and/or of the second row (a, b) are plug openings (124, 126, 136; 134, 150, 154) and/or cable openings (66).

3. Electronic control unit according to Claim 1 or 2, characterized in that connection plugs (50) of the mother board (20) and/or of the additional printed circuit board (38) are accessible through the plug openings (134, 150, 154) of the second row (b).

4. Electronic control unit according to one of Claims 1 to 3, characterized in that a card slot for a PCMCIA card can be installed between the mother board (20) and the additional printed circuit board (38), the receiving aperture of the said card slot being accessible through an aperture of the second row (b).

5. Electronic control unit according to one of Claims 1 to 3, characterized in that a card slot (56) for a PCMCIA card (60) can be installed between the mother board (20) and the additional printed circuit board (38), the receiving aperture (58) of the card slot (56) being arranged offset by 90° with respect to the housing wall (18) and being set back into the interior of the housing to such an extent that a cable routing space is produced from the receiving aperture (58) as far as a cable opening (66).

## Revendications

1. Appareil de commande électronique comportant un boîtier, dans lequel une carte à circuit imprimé de base portant des prises de raccordement sur un bord et en parallèle à celle-ci au moins une carte supplémentaire à circuit imprimé portant un panneau suivant la norme PC sont montées, les prises de raccordement de la carte à circuit imprimé de base étant accessibles par des ouvertures disposées dans une première rangée et le panneau étant accessible par une ouverture parallèle à celle-ci dans une paroi du boîtier,
caractérisé en ce que
il est disposé entre la première rangée (a) d'ouvertures (66, 124, 126, 136) et l'ouverture (70) pour le panneau (46) une deuxième rangée (b), parallèle à celles-ci, d'ouvertures (134, 150, 154), une carte (28) à circuit imprimé fille munie de prises (34, 36) de raccordement peut être enfichée sur la carte (20) à circuit imprimé de base et/ou sur la carte (38) à circuit imprimé supplémentaire et leurs prises (34 ; 36) de raccordement sont accessibles par des ouvertures (134 ; 136) de la première (a) et/ou de la deuxième rangée (b).

2. Appareil de commande électronique suivant la revendication 1,
caractérisé en ce que
les ouvertures de la première et/ou de la deuxième rangée (a, b) sont des passages de prises (124, 126, 136 ; 134, 150, 154) et/ou des passages (66) de câbles.

3. Appareil de commande électronique suivant la revendication 1 ou 2,
caractérisé en ce que
des prises (50) de raccordement de la carte (20) à circuit imprimé de base et/ou de la carte (38) à circuit imprimé supplémentaire sont accessibles par les passages (134, 150, 154) de prises de la deuxième rangée (b).

4. Appareil de commande électronique suivant l'une des revendications 1 à 3,
caractérisé en ce qu'un logement de carte pour une carte PCMCIA, dont l'ouverture de réception est accessible par une ouverture de la deuxième rangée (b), peut être inséré entre la carte (20) à circuit imprimé de base et la carte (38) à circuit imprimé supplémentaire.

5. Appareil de commande électronique suivant l'une des revendications 1 à 3,
caractérisé en ce qu'un logement (56) de carte pour une carte (60) PCMCIA, dont l'ouverture (58) de réception est disposée en étant décalée de 90° par rapport à la paroi (18) d'un boîtier et qui est en retrait à l'intérieur du boîtier, de sorte à ménager un espace de guidage de câble de l'ouverture (58) de réception jusqu'à un passage (66) de câble, peut être inséré entre la carte (20) à circuit imprimé de base et la carte (38) à circuit imprimé supplémentaire.
